Europäisches Patentamt

European Patent Office

Office européen des brevets

(19)

(11) Veröffentlichungsnummer: **0 111 750**
**B1**

(12) **EUROPÄISCHE PATENTSCHRIFT**

(45) Veröffentlichungstag der Patentschrift:
01.03.89

(51) Int. Cl.⁴: **H 01 L 31/02**, H 01 L 31/18

(21) Anmeldenummer: 83111370.9

(22) Anmeldetag: **14.11.83**

(54) Solarzelle aus amorphem Silizium und Verfahren zu ihrer Herstellung.

(30) Priorität: **19.11.82 DE 3242831**

(43) Veröffentlichungstag der Anmeldung:
**27.06.84 Patentblatt 84/26**

(45) Bekanntmachung des Hinweises auf die Patenterteilung:
**01.03.89 Patentblatt 89/9**

(84) Benannte Vertragsstaaten:
**DE FR GB IT**

(56) Entgegenhaltungen:
DE-A- 3 023 165
DE-A- 3 049 226
US-A- 4 064 521
US-A- 4 064 521

SOLAR ENERGY, Band 27, Nr. 4, 1981, Seiten 283-287, Pergamon Press Ltd., Oxford, GB; M. MÄENPÄÄ u.a.: "Contact resistivities of sputtered TiN and Ti-TiN metallizations on solar-cell-type-silicon"
APPLIED PHYSICS LETTERS, Band 36, Nr. 6, 5. März 1980, Seiten 456-458, American Institute of Physics, New York, US; M. WITTMER: "TiN and TaN as diffusion barriers in metallizations to silicon semiconductor devices"
IEEE TRANSACTIONS ON ELECTRON DEVICES, Band ED-27, nr. 4, April 1980, Seiten 873-876, IEEE, New York,

(73) Patentinhaber: **Siemens Aktiengesellschaft Berlin und München, Wittelsbacherplatz 2, D-8000 München 2 (DE)**

(72) Erfinder: **Möller, Matthias, Dipl.-Phys., Plievierpark 12, D-8000 München 83 (DE)**
Erfinder: **Kausche, Helmold, Dipl.-Phys., Tessinerstrasse 146, D-8000 München 71 (DE)**

(56) Entgegenhaltungen: (Fortsetzung)
US; H. VON SEEFELD u.a.: "Investigation of titanium-nitride layers for solar-cell contacts" THE CONFERENCE RECORD OF THE FIFTEENTH IEEE PHOTOVOLTAIC SPECIALISTS CONFERENCE, 12-15. Mai 1981, Kissimmee, Florida, Seiten 518-520, IEEE, New York, US; M. MÄENPÄÄ u.a.: "Contact resistivities between solar-cell-type Si and transition metal nitrides"

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die Patentanmeldung betrifft eine Solarzelle mit einem aus amorphem Silizium bestehenden Halbleiterkörper, der auf einem zumindest an seiner Oberfläche mit einer als Rückkontakt dienenden, aus Aluminium bestehenden Metallschicht versehenen Substrat aufgebracht ist. Eine solche Solarzelle ist aus der DE-A-3 023 165 bekannt.

Der Aufbau von Solarzellen aus amorphem Silizium (= a-Si) auf isolierenden, nicht notwendig transparenten Trägern wie Glas, Keramik oder Kapton-Folie (= Polyimidfolie) ist von besonderer Bedeutung, da hier serienverschaltete Solarzellen auf einem Träger durch einfache Maskentechnik hergestellt werden können. Als Rückkontakt muß dazu zunächst eine Metallschicht mit niedrigem Flächenwiderstand (ca. 50 m Ohm bei 50 cm$^2$ Zellengröße) auf den Träger aufgebracht werden.

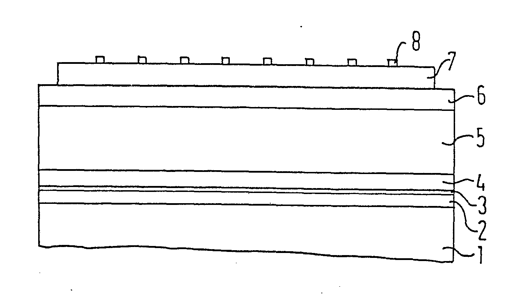

Aus dem Tagungsband der 15th IEEE Photovoltaic Specialists Conference, Florida (1981), Seiten 922 bis 927 (Figur 1), ist es bekannt, als Substratmaterial Edelstahlscheiben zu verwenden.

Wegen seiner hohen Leitfähigkeit und Preiswürdigkeit ist Aluminium als Rückkontakt besonders geeignet. Entscheidend ist bei der Herstellung durch Hochfrequenz-Zerstäuben (HF-Sputtern), daß die Kristallitgröße der Aluminiumschicht kleiner 500 nm ist, was an der spiegelnden Oberfläche erkennbar ist und durch Einlegieren von Silizium erreicht wird, und daß die Schicht wegen der darauffolgenden a-Si:H Abscheidung, die bei 250 °C erfolgt, thermisch stabil ist. Die hergestellten Aluminiumschichten erfüllen diese Anforderungen.

Aluminium konnte aber bisher nicht als Substratmaterial für amorphe Silizium-Zellen verwendet werden, da Aluminium bereits bei Temperaturen von ca. 150 °C stark in das amorphe Silizium eindiffundiert und damit den Zellenwirkungsgrad stark beeinträchtigt.

Aufgabe der Erfindung ist es daher, die Anwendung von Aluminium als Rückkontaktmetallschicht und damit als Substratmaterial für Solarzellen möglich zu machen.

Diese Aufgabe wird durch eine Solarzelle der eingangs genannten Art dadurch gelöst, daß die Aluminiumschicht auf der dem amorphen Siliziumkörper zugewandten Seite mit einer Diffusionssperrschicht aus Titan-Nitrid versehen ist.

Titan-Nitrid als Diffusionssperrschicht ist aus Applied Physics Letters 36 (6) (15.03.1980) Seiten 456 bis 458 bekannt. Dort wird Titan-Nitrid als Diffusionsbarriere bei aus Nickel bestehenden Metallisierungen von Siliziumhalbleiterbauelementen verwendet.

Neben der Vermeidung der Aluminium-Diffusion in den amorphen Siliziumkörper wird bei der Erfindung durch die Verwendung der Titan-Nitrid-Schicht die hohe Härte dieser Schicht dazu ausgenutzt, die anschließend aufgebrachte amorphe Silizium-Zelle gegen mechanische Beanspruchung, wie sie beispielsweise entsteht beim Auflegen der Masken bei der Deckelelektrodenherstellung, unempfindlich zu machen.

Gegenüber einer reinen Titanschicht sind die höhere Sperrwirkung sowie die Tatsache von Vorteil, daß die Kristallitgröße der Titan-Nitrid-Schicht klein ist, die Schicht also spiegelnd glatt ist.

Der Flächenwiderstand der im Bereich von 0,1 bis 0,5 µm, vorzugsweise bei 0,2 µm liegenden Titan-Nitrid-Schicht beträgt 200 Ohm. Dieser Wert liegt 10 mal höher als der Widerstand einer reinen Titanschicht, was vermutlich mit dem Stickstoff-Einbau zusammenhängt. Der Widerstand ist aber niedrig genug, um sich nicht als Serienwiderstand in der Zellenfunktion meßbar auszuwirken, wie durch die Herstellung kleiner (6 mm$^2$ großer) Zellen auf reinen Titan-Nitrid-Schichten im Vergleich zu solchen auf (niederohmigen) Chrom-Nickel-Schichten nachgewiesen wurde.

Es liegt im Rahmen der Erfindung, die Titan-Nitrid-Schicht durch Hochfrequenz-Zerstäuben unter Verwendung eines aus Titan bestehenden Targets in einer Stickstoff enthaltenden Gasatmosphäre herzustellen und anschließend den amorphen Siliziumhalbleiterkörper durch thermische Zersetzung einer Silizium enthaltenden gasförmigen Verbindung, der gegebenenfalls Dotierstoffe zugesetzt sind, in einem Glimmentladungsplasma abzuscheiden. Zweckmäßigerweise wird ein Argongasdruck von $3 \times 10^{-2}$ Torr ($4 \times 10^{-2}$ millibar) und ein Stickstoffdruck von $0,2 \times 10^{-2}$ Torr ($3 \times 10^{-2}$ millibar) bei einer Leistung von 3 W/cm$^2$ in der Zerstäubungsanlage eingestellt. Nähere Einzelheiten sind aus dem Aufsatz von M. Wittmer aus Appl. Phys. Lett. 36 (6) vom 15. März 1980 auf den Seiten 456 bis 458 zu entnehmen.

Der Aufbau einer erfindungsgemäßen Solarzelle (pin/ITOZelle) ist der in der Zeichnung befindlichen Figur zu entnehmen. Dabei ist mit den Bezugszeichen

1 = Substratkörper zum Beispiel aus Glas,
2 = Aluminiumschicht (200 bis 2000 nm),
3 = Titan-Nitrid-Schicht (200 nm),
4 = amorphe Siliziumschicht (p-dotiert 20 nm),
5 = amorphe Siliziumschicht (Intrinsic 500 nm),
6 = amorphe Siliziumschicht (n-dotiert 10 nm),
7 = Indiumoxid-Zinnoxid-Schicht (= ITO, Antireflexschicht 70 nm) und
8 = Fingerelektrodenstruktur
bezeichnet.

**Patentansprüche**

1. Solarzelle mit einem aus amorphem Silizium bestehenden Halbleiterkörper, der auf einem zumindest an seiner Oberfläche mit einer als Rückkontakt dienenden, aus Aluminium bestehenden Metallschicht versehenen Substrat aufgebracht ist, dadurch gekennzeichnet, daß die Aluminiumschicht (2) auf der dem amorphen Siliziumkörper (4, 5, 6) zugewandten Seite mit einer Diffusionssperrschicht (3) aus Titan-Nitrid versehen ist.

2. Solarzelle nach Anspruch 1, dadurch gekennzeichnet, daß bei einer Schichtdicke der Titan-Nitrid-Schicht (3) von 100 bis 500 µm, vorzugsweise 200 µm, der Flächenwiderstand 200 Ohm beträgt.

3. Verfahren zum Herstellen einer Solarzelle nach Anspruch 1 und/oder 2, dadurch gekennzeichnet, daß die Titan-Nitrid-Schicht (3) durch Hochfrequenzzerstäuben unter Verwendung eines aus Titan bestehenden Targets in einer Stickstoff enthaltenden Gasatmosphäre auf das mit der Aluminiumschicht (2) versehene Substrat (1) aufgebracht wird und daß anschließend der amorphe Siliziumhalbleiterkörper (4, 5, 6) durch thermische Zersetzung einer Silizium enthaltenden gasförmigen Verbindung, der gegebenenfalls Dotierstoffe zugesetzt sind, unter Einwirkung eines Glimmentladungsplasmas abgeschieden wird.

4. Verfahren nach Anspruch 3, dadurch gekennzeichnet, daß ein Argongasdruck von $4 \cdot 10^{-2}$ millibar und ein Stickstoffdruck von $3 \cdot 10^{-3}$ mb bei einer HF-Leistung von 3 W/cm$^2$ eingestellt wird.

**Claims**

1. A solar cell comprising a semiconductor body which consists of amorphous silicon and which is applied to a substrate which is provided, at least at its surface, with a metal layer which serves as rear contact and consists of aluminium, characterised in that the aluminium layer (2) is provided on the side facing towards the amorphous silicon body (4, 5, 6), with a diffusion blocking layer (3) made of titanium nitride.

2. A solar cell as claimed in Claim 1, characterised in that where the titanium nitride layer (3) has a layer thickness of 100 to 500 µm, preferably 200 µm, the surface resistance amounts to 200 Ohms.

3. A process for the production of a solar cell as claimed in Claim 1 and/or 2, characterised in that the titanium nitride layer (3) is applied to the substrate (1), provided with the aluminium layer (2), by high-frequency sputtering using a target made of titanium in a gas atmosphere containing nitrogen, and that the amorphous silicon semiconductor body (4, 5, 6) is then deposited by the thermal decomposition of a gaseous compound which contains silicon and to which dopants may have been added, under the influence of a glow discharge plasma.

4. A process as claimed in Claim 3, characterised in that an argon gas pressure of $4 \cdot 10^{-2}$ millibars and a nitrogen pressure of $3 \cdot 10^{-3}$ mb are set at a HF-power of 3 W/cm$^2$.

**Revendications**

1. Cellule solaire comprenant un corps semi-conducteur en silicium amorphe, qui est déposé sur un substrat muni au moins sur sa surface d'une couche métallique en aluminium servant de contact arrière, caractérisée en ce que la couche d'aluminium (2) est munie, du côté tourné vers le corps de silicium amorphe (4, 5, 6), d'une couche en nitrure de titane empêchant la diffusion (3).

2. Cellule solaire suivant la revendication 1, caractérisée en ce que, pour une épaisseur de la couche (3) en nitrure de titane de 100 à 500 µm et de préférence de 200 µm, la résistance superficielle est de 200 ohm.

3. Procédé de fabrication d'une cellule solaire suivant la revendication 1 et/ou 2, caractérisé en ce que la couche (3) de nitrure de titane est déposée sur le substrat muni de la chouche d'aluminium (2) par pulvérisation cathodique sous haute fréquence, en utilisant une cible en titane dans une atmosphère gazeuse contenant de l'azote et en ce qu'ensuite le corps semi-conducteur (4, 5, 6) en silicium amorphe est déposé par décomposition thermique d'un composé gazeux, contenant du silicium et additionné, le cas échéant, de substances de dopage, sous l'effet d'un plasma à décharge luminescente.

4. Procédé suivant la revendication 3, caractérisé en ce qu'il est établi une pression d'argon gazeux de $4 \cdot 10^{-2}$ millibar et une pression d'azote de $3 \cdot 10^{-3}$ mb pour une puissance HF de 3 W/cm$^2$.